# EUROPEAN PATENT APPLICATION

(11) **EP 2 849 547 A1**
(43) Date of publication of application: **18.03.2015**
(21) Application number: 13787362.6
(22) Date of filing: 11.04.2013
(51) Int. Cl.: H05K 3/34, H05K 1/02

(54) **SURFACE-MOUNTING SUBSTRATE**

(30) Priority: 11.05.2012 JP 2012109463
(71) Applicant: Fuji Electric FA Components & Systems Co. Ltd., Tokyo 103-0011 (JP)
(72) Inventor: OKAMOTO, Koukichi, Tokyo 103-0011 (JP); TAGUCHI, Takahiro, Tokyo 103-0011 (JP)
(74) Representative: Eidelsberg, Olivier Nathan
(86) International application number: PCT/JP2013/002478
(87) International publication number: WO 2013/168357

(57) **Abstract**

There is provided a surface mounting substrate on which electronic parts are surface mounted using lead-free solder, wherein it is possible to suppress an occurrence of a crack of the electronic parts, or a crack of joint portions, caused by heat cycle stress or external stress. The surface mounting substrate is a surface mounting substrate (1) on which electronic parts (4), (5) are surface mounted using lead-free solder, wherein stress relaxation portions (11a), (11b), (16) are formed in the vicinities of joint portions of the substrate to which the electronic parts (4), (5) are joined.

## Description

### Technical Field

The present invention relates to a surface mounting substrate on which electronic parts are surface mounted using lead-free solder.

### Background Art

With this kind of surface mounting substrate, when soldering electronic parts with lead-free solder, a stress crack of solder joint portions of chip parts or a crack of the chip parts is likely to occur due to stress concentration on the solder joint portions in a heat cycle environment or to solder residual stress on the chip parts near large parts. The chip parts are stressed by warp or distortion of the substrate when assembling, and a break of the parts or a crack of the solder joint portions is likely to occur.

Meanwhile, when using a BGA method or CSP method whereby semiconductor elements and a printed wiring board are connected by a plurality of solder balls disposed in an array form, the linear expansion coefficient of an epoxy resin or glass epoxy resin forming the printed wiring board is on the order of about 10 times higher than the linear expansion coefficient of IC chips, made of silicon, which form the semiconductor elements.

Because of this, in a heating and cooling step in a solder reflow process or the like, when the printed wiring board is exposed to a high temperature of 200 degrees or more, the printed wiring board extends more dramatically than the semiconductor elements, including the CI chips, which have a lower linear expansion coefficient. The printed wiring board warps significantly due to this difference in linear expansion coefficient, as a result of which high stress is applied to the solder balls. Because of this, a crack occurs in the solder balls, or the joints of the semiconductor elements and printed wiring board are disconnected. Also, after the printed wiring board has been mounted in a product, it may happen that stress is accumulated in the solder balls due to a heat cycle resulting from power on and off, thus leading to a fracture before long.

A multilayer printed circuit board described in PTL 1 is proposed in order to reduce only joint stress occurring in the solder balls to which highest stress is applied due to the difference in linear expansion coefficient.

That is, the multilayer printed circuit board is such that a plurality of lands on which semiconductor elements are mounted via solder are disposed on a resin layer of an outermost layer of a multilayer printed wiring board formed of a plurality of stacked resin layers and a plurality of wiring pattern layers formed on the interfaces of a plurality of resin layers. Also, at least one of the wiring pattern layers is formed into a mesh opening pattern layer whose opening portions are formed in a mesh. Further, an opening portion in a region positioned below a land to which is joined solder which has the greatest concentration of stress as a result of a thermal deformation of the semiconductor elements and multilayer printed wiring board is made larger in size than the opening portions in the other regions.

### Citation List

### Patent Literature

PTL 1: JP-A-2006-13455

### Summary of Invention

### Technical Problem

Meanwhile, in the heretofore described heretofore known example described in PTL 1, the opening portion, of the wiring pattern layer whose opening portions are formed in a mesh, in the region positioned below the land to which is connected a solder ball which has the greatest concentration of stress is increased in size compared with the opening portions in the other regions. Because of this, it is possible to reduce only the thermal expansion coefficient of an inner layer corresponding to the solder ball which has the greatest concentration of stress.

However, in the heretofore described heretofore known example, it is possible to suppress the difference between the linear expansion coefficient of an epoxy resin or glass epoxy resin forming the printed wiring board and the linear expansion coefficient of the IC chips, made of silicon, which form the semiconductor elements, but there is an unsolved problem that the heretofore known example is applicable only when it is possible to specify a solder ball which has the greatest concentration of stress, and is not applicable in the case of lead-free solder which uses no solder ball.

Therefore, the invention, having been contrived focusing attention on the heretofore described unsolved problem of the heretofore known example, has an object of providing a surface mounting substrate on which electronic elements are surface mounted using lead-free solder, wherein it is possible to suppress an occurrence of a crack of the electronic elements, or a crack of joint portions, caused by heat cycle stress or external stress.

### Solution to Problem

In order to achieve the heretofore described object, a first aspect of a surface mounting substrate according to the invention is a surface mounting substrate on which electronic parts are surface mounted using lead-free solder. The surface mounting substrate is such that stress relaxation portions are formed in the vicinities of joint portions of the substrate to which the electronic parts are joined.

According to the first aspect, as stress relaxation portions are formed in the vicinities of joint portions of the substrate to which the electronic parts are joined, it is possible to divide stress, acting on the joint portions of the substrate to which the electronic parts are joined, with the stress relaxation portions, and thus reduce stress acting on the joint portions of the substrate or on the electronic parts via the joint portions of the substrate, thereby improving the connection reliability of the joint portions.

Also, a second aspect of the surface mounting substrate according to the invention is such that the stress relaxation portions are configured of through holes passing through at least a front surface layer on which the electronic parts are mounted.

According to the second aspect, when the surface mounting substrate is configured of one substrate, through holes passing through the substrate are formed, and when the surface mounting substrate is configured of a multilayer substrate, through holes passing through a front surface layer on which the electronic parts are surface mounted are formed. By so doing, it is possible to divide stress, acting on the joint portions of the substrate to which the electronic parts are joined, with the through holes, and thus reduce stress acting on chip parts with less strength or on the joint portions of the substrate.

Also, a third aspect of the surface mounting substrate according to the invention is such that the through holes are formed of either circular holes or elongated circular holes.

According to the third aspect, as the through holes are formed of either circular holes or elongated circular holes, it is possible, when forming circular holes, to bore them with a drill, and it is possible to easily carry out the formation of the through holes. It is possible, when forming elongated circular holes, to divide stress acting on large electronic parts or stress occurring in fixing screw mounting portions.

Also, a fourth aspect of the surface mounting substrate according to the invention is such that the stress relaxation portions are formed between fixing screw mounting portions tightened on and fixed to fixed portions and the joint portions to which the electronic parts are joined.

According to the fourth aspect, it is possible to relax stress, occurring when tightening the fixing screws with the fixing screw mounting portions, with the stress relaxation portions, and thus possible to reduce stress acting on the joint portions of the substrate to which are joined the electronic parts around the fixing screw mounting portions.

### Advantageous Effects of Invention

According to the invention, as the stress relaxation portions are formed in the vicinities of the joint portions of the surface mounting substrate to which the electronic parts are joined, it is possible to relax stress transferred to the joint portions of the substrate or to the electronic parts via the joint portions of the substrate, thus improving the connection reliability of lead-free solder joint portions.

### Brief Description of Drawings

[Fig. 1] Fig. 1 is a plan view showing a surface mounting substrate according to the invention.
[Fig. 2] Fig. 2 is a sectional view taken along the line A-A of Fig. 1.

### Description of Embodiments

Hereafter, a description will be given, based on the drawings, of an embodiment of the invention.

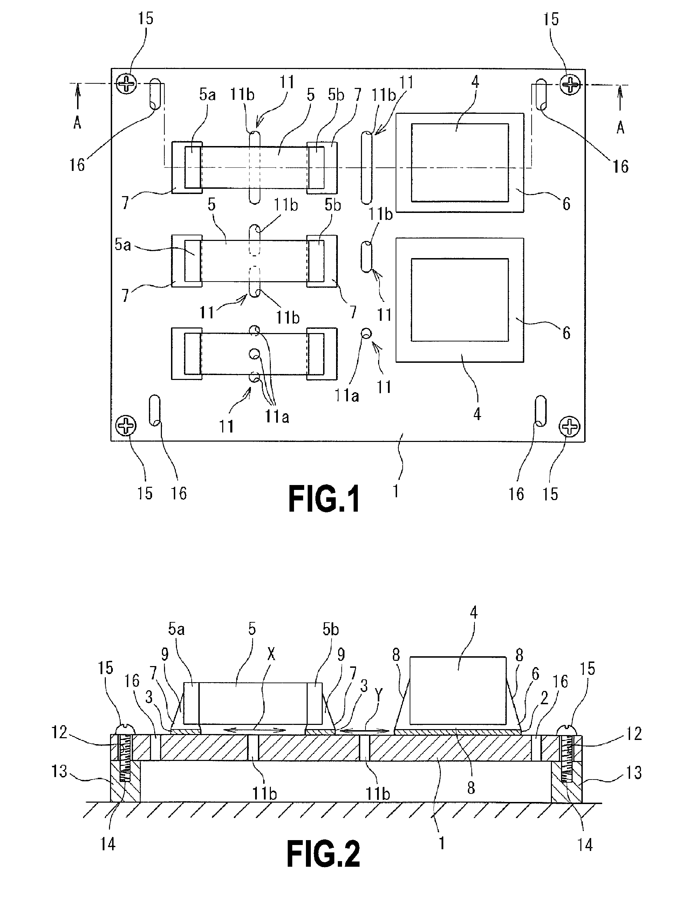

Fig. 1 is a plan view showing a surface mounting substrate according to the invention, and Fig. 2 is a sectional view taken along the line A-A of Fig. 1

In the drawings, 1 is a surface mounting substrate, formed of one substrate, on which are surface mounted electronic parts configuring a drive circuit which drives, for example, an electromagnet unit of an electromagnetic contactor. The surface mounting substrate 1 is such that large parts 4 formed of semiconductor parts, such as a rectifier diode, a Schottky diode, and a field-effect transistor, are reflow soldered to, and chip parts 5, such as a resistor, a capacitor, and a coil, are reflow soldered to lands 2 and 3 formed on the front surface of the surface mounting substrate 1.

Herein, for the reflow soldering, firstly, lead-free solder paste is screen printed in advance on the lands 2 and 3 forming part mounting portions of the surface mounting substrate 1. Herein, for the large parts 4, lead-free solder paste 6 is disposed on the whole of a surface below each large part 4 which forms a mounting surface. Also, for each of the chip parts 5, lead-free solder paste 7 is disposed in positions opposite to electrode portions 5a and 5b at two ends in an axial direction.

Further, the large parts 4 and chip parts 5, after being mounted on the lead-free solder pastes 6 and 7, are heated in a reflow furnace. At this time, preheating and main heating are carried out in the reflow furnace. In the preheating, the substrate and parts are preheated to, in general, on the order to 150°C to 170°C in order to carry out relaxation of sudden thermal shock given to the parts, promotion of flux activation, organic solvent vaporization, and the like. Subsequently, the main heating wherein the temperature is raised to a high temperature (in general, 220°C to 260°C), at which solder melts, for a short time is carried out. In the main heating, it is necessary to raise the temperature to a high temperature when using lead-free solder although the melting temperature varies according to the solder component composition.

Further, through holes 11 acting as stress relaxation portions are formed in portions of the surface mounting substrate 1 in the vicinities of the large parts 4 and between the electrodes of the chip parts 5. The through holes 11 can be configured of either circular holes 11a or elongated circular holes 11b, and the number of circular holes 11a and the length of elongated circular holes 11b are set in accordance with stress intended to be relaxed.

Furthermore, screw insertion holes 12 are formed in, for example, four corners of the surface mounting substrate 1. Further, the surface mounting substrate 1 is mounted on substrate mounting portions 13. That is, internal thread portions 14 are formed in the substrate mounting portions 13 so as to be opposite to the screw insertion holes 12 of the surface mounting substrate 1. In a condition in which the screw insertion holes 12 of the surface mounting substrate 1 are aligned with the internal thread portions 14, fixing screws 15 are inserted into the screw insertion holes 12 from above the surface mounting substrate 1, threaded onto the internal thread portions 14, and tightened, thereby fixing the surface mounting substrate 1 to the substrate mounting portions 13.

Consequently, as external stress occurs by tightening the fixing screws 15, elongated circular holes 16 acting as stress relaxation portions are formed one in each portion between the screw insertion hole 12 and the large part 4 or chip part 5 in the vicinity thereof.

Further, the surface mounting substrate 1 on which are mounted the large parts 4 and chip parts 5 are installed in, for example, an electromagnetic contactor inserted in a high-voltage and high-current direct current path, thus controlling current conduction in a harsh heat cycle environment.

Next, a description will be given of an operation of the heretofore described embodiment.

Firstly, when forming through holes (not shown) in advance in the surface mounting substrate 1, or separately, the circular holes 11a or elongated circular holes 11b are bored in positions on the surface mounting substrate 1 on which stress acts, that is, around the large parts 4 or between the electrode portions 5a and 5b of the chip parts 5, and the elongated circular holes 16 are also bored between the screw insertion holes 12 and the large parts 4 or chip parts 5 in the vicinities thereof.

After that or before that, wiring patterns, including copper lands, are formed on the surface mounting substrate 1.

Further, the lead-free solder pastes 6 and 7 are screen printed on a mounting surface on which the large parts 4 and chip parts 5 are surface mounted.

Subsequently, the large parts 4 and chip parts 5, after being mounted on the screen printed lead-free solder pastes 6 and 7, are conveyed to the reflow furnace, and after the preheating and main heating are carried out, cooling is carried out, thereby carrying out reflow soldering, thus soldering the large parts 4 and chip parts 5 to the surface mounting substrate 1.

The surface mounting substrate 1 on which the large parts 4 and chip parts 5 are surface mounted in this way is disposed in the electromagnetic contactor inserted in the high-voltage and high-current direct current path, but the electromagnetic contactor is placed in a heat cycle environment wherein the temperature in an environment around a motor vehicle or the like varies enormously.

Because of this, stress concentration on solder joint portions 9 of the chip part 5, shown by the arrow X in Fig. 2, occurs in the heat cycle environment. Also, solder residual stress in a solder joint portion 8 of the large part 4 acts on the neighboring solder joint portion 9 of the chip part 5, as shown by the arrow Y in Fig. 2.

However, as the through holes 11 formed of a predetermined number of circular holes 11a or a predetermined length of elongated circular holes 11b are formed in positions on the surface mounting substrate 1 in which stress occurs, it is possible to cause the concentration of, for example, stress, acting on the chip parts 5, in a direction in which the chip parts 5 are stretched, upon the circular holes 11a or elongated circular holes 11b formed between the lands 3 to which the electrode portions 5a and 5b are soldered, thus relaxing the stress acting on the chip parts 5 and the solder joint portions 9 thereof.

In the same way, it is also possible to cause the concentration of solder residual stress on the solder joint portions 8 of the large parts 4, upon the circular holes 11a or elongated circular holes 11b disposed around the solder joint portions 8, thus relaxing the stress acting on the solder joint portions 9 of the chip parts 5.

Furthermore, when fixing the surface mounting substrate 1 to the substrate mounting portions 13, there occurs external stress caused by an external factor resulting from the fixing screws 15 being threaded onto the internal thread portions 14 formed in the substrate mounting portions 13 through the screw insertion holes 12 and tightened. For the external stress, as the elongated circular holes 16 are formed between the screw insertion holes 12 and the large parts 4 or chip parts 5 in the vicinities thereof, it is also possible to cause stress concentration on the elongated circular holes 16, thus relaxing the external stress acting on the large parts 4 or chip parts 5.

In the same way, stress caused by warp occurring when molding the surface mounting substrate 1 can also be relaxed by the circular holes 11a or elongated circular holes 11b provided around or inside the large parts 4 or chip parts 5.

In this way, in the heretofore described embodiment, the circular holes 11a and elongated circular holes 11b and 16 are formed in the positions in which there occurs the stress acting on the large parts 4 or chip parts 5 mounted on the surface mounting substrate 1. As the stress relaxation portions are configured by the circular holes 11a and elongated circular holes 11b and 16, it is possible to relax the stress acting on the large parts 4 and chip parts 5 and on the solder joint portions 9 of the chip parts 5.

Consequently, it is possible to improve heat cycle resistance even when using the electromagnetic contactor in a heat cycle environment in which the temperature in an external environment varies drastically as in the case of, for example, a motor vehicle. Also, it is possible to divide stress, such as warp, distortion, or solder residual stress of the surface mounting substrate 1, with the stress relaxation portions, and thus possible to reliably prevent a crack or break from occurring in the large parts and chip parts or the solder joint portions thereof.

In the heretofore described embodiment, a description has been given of a case in which the surface mounting substrate 1 is configured of one substrate, but the invention not being limited to this, when the surface mounting substrate 1 is formed of a multilayer substrate, it is only necessary to form the stress relaxation portions on only a front surface layer on which the large parts 4 and chip parts 5 are mounted.

Also, in the heretofore described embodiment, a description has been given of a case in which the large parts 4 and chip parts 5 are mounted on only the front surface of the surface mounting substrate 1, but the invention not being limited to this, a configuration may be such that the large parts 4 or chip parts 5 are mounted on only the rear surface or both the front and rear surfaces of the surface mounting substrate 1.

Furthermore, in the heretofore described embodiment, a description has been given of a case in which the elongated circular holes 11b are applied as the stress relaxation portions, but the invention not being limited to this, a configuration may be such that elliptical holes are formed in place of the circular holes, or slit holes are formed in place of the elongated circular holes 11b. In sum, it is possible to apply any hole shape which is a hole shape which can achieve stress relaxation.

Also, in the heretofore described embodiment, a description has been given of a case in which the elongated circular holes 11b configuring the stress relaxation portions extend in a linear form, but the invention not being limited to this, it is possible to form the elongated circular holes 11b into any shape such as a circular arc shape or an L-shape.

### Industrial Applicability

According to the invention, it is possible to provide a surface mounting substrate on which electronic parts are surface mounted using lead-free solder, wherein as stress relaxation portions are formed in the vicinities of joint portions of the surface mounting substrate to which the electronic parts are joined, it is possible to suppress an occurrence of a crack of the electronic parts, or a crack of the joint portions, caused by heat cycle stress or external stress.

### Reference Signs List

1 ··· Surface mounting substrate, 2, 3 ··· Land, 4 ··· Large part, 5 ··· Chip part, 6, 7 ··· Lead-free solder paste, 11 ··· Through hole, 11a ··· Circular hole, 11b ··· Elongated circular hole, 12 ··· Screw insertion hole, 13 ··· Substrate mounting portion, 14 ··· Internal thread portion, 15 ··· Fixing screw, 16 ··· Elongated circular hole

## Claims

1. A surface mounting substrate on which electronic parts are surface mounted using lead-free solder, the surface mounting substrate being **characterized in that**
stress relaxation portions are formed in the vicinities of joint portions of the substrate to which the electronic parts are joined.

2. The surface mounting substrate according to claim 1, **characterized in that**
the stress relaxation portions are configured of through holes passing through at least a front surface layer on which the electronic parts are mounted.

3. The surface mounting substrate according to claim 2, **characterized in that**
the through holes are formed of either circular holes or elongated circular holes.

4. The surface mounting substrate according to any one of claims 1 to 3, **characterized in that**
the stress relaxation portions are formed between fixing screw mounting portions tightened on and fixed to fixed portions and the joint portions to which the electronic parts are joined.
